# EUROPEAN PATENT APPLICATION

(11) **EP 4 610 679 A1**
(43) Date of publication of application: **03.09.2025**
(21) Application number: 23882658.0
(22) Date of filing: 25.10.2023
(51) Int. Cl.: G01R 31/392, G01R 31/367, G01R 31/382, G01R 31/396, H01M 10/48, H02J 7/00

(54) **INFORMATION PROCESSING METHOD, INFORMATION PROCESSING SYSTEM, AND PROGRAM**

(30) Priority: 26.10.2022 JP 2022171723
(71) Applicant: GS Yuasa International Ltd., Kisshoin, Minami-ku, Kyoto-shi, Kyoto 601-8520 (JP)
(72) Inventor: UKUMORI Nan, Kyoto-shi, Kyoto 601-8520 (JP)
(74) Representative: Grünecker Patent- und Rechtsanwälte PartG mbB
(86) International application number: PCT/JP2023/038412
(87) International publication number: WO 2024/090453

(57) **Abstract**

An information processing method includes: acquiring measurement data of a plurality of energy storage devices; executing, based on measurement data of a first energy storage device group selected from the plurality of energy storage devices, a first process for estimating a degradation state of the first energy storage device group; extracting, from among the plurality of energy storage devices, a second energy storage device to be subjected to a second process; and executing, based on measurement data of the extracted second energy storage device, a second process for estimating a degradation state of the second energy storage device.

## Description

### TECHNICAL FIELD

The present invention relates to an information processing method, an information processing system, and a program.

### BACKGROUND ART

Use of an energy storage device in a large-scale system which stores renewable energy or electric power generated by an existing power generation system is expanding. It is known that degradation of an energy storage device progresses by repeating charge and discharge, and that the energy storage capacity gradually decreases. In order to effectively utilize the energy storage devices included in the energy storage system, it is important to grasp to what extent an energy storage capacity decreases.

Patent Literature 1 discloses a storage battery apparatus which performs degradation prediction by using data of a usage condition and a degradation rate based on measurement data of a current, a voltage, and a temperature of an energy storage device, thereby increasing accuracy of a predicted value of the degradation rate and accurately predicting a lifetime.

### CITATION LIST

### Patent Literature

Patent Literature 1: Japanese Unexamined Patent Publication No. 2015-121520

### DISCLOSURE OF INVENTION

### PROBLEMS TO BE SOLVED BY THE INVENTION

A large-scale energy storage system is configured by using a plurality of energy storage devices. For example, in a large-scale photovoltaic power generation system called mega solar, a very large number of energy storage devices, such as several millions, are installed, and the number thereof is much larger than the number of energy storage devices used for power, auxiliary machines, or the like of each vehicle, for example.

In such a large-scale energy storage system, an enormous amount of measurement data regarding numerous energy storage devices is acquired. Regarding monitoring of a large-scale energy storage system, it is required to accurately monitor the state of an energy storage device, whereas it is not realistic to randomly perform state analysis on all energy storage devices included in the system for the entire period and at a high frequency. Regarding processing of measurement data from a large-scale energy storage system, sufficient studies have not yet been conducted on accurately monitoring a degradation state while suppressing an increase in processing load.

An object of the present disclosure is to provide an information processing method and the like that can accurately monitor the degradation state of an energy storage device while suppressing an increase in a processing load of measurement data related to a large-scale energy storage system.

### MEANS FOR SOLVING THE PROBLEMS

An information processing method according to an aspect of the present disclosure includes: acquiring measurement data of a plurality of energy storage devices; executing, based on measurement data of a first energy storage device group selected from the plurality of energy storage devices, a first process for estimating a degradation state of the first energy storage device group; extracting, from among the plurality of energy storage devices, a second energy storage device to be subjected to a second process; and executing, based on measurement data of the extracted second energy storage device, a second process for estimating a degradation state of the second energy storage device.

### EFFECT OF THE INVENTION

According to the present disclosure, it is possible to accurately monitor a degradation state while suppressing an increase in a processing load of measurement data related to a large-scale energy storage system.

### BRIEF DESCRIPTION OF DRAWINGS

FIG. 1 is a diagram illustrating an overview of a remote monitoring system according to an embodiment.
FIG. 2 is a block diagram illustrating a configuration example of a power generation system.
FIG. 3 is a block diagram illustrating a configuration example of an information processing apparatus.
FIG. 4 is a block diagram illustrating a configuration example of a terminal apparatus.
FIG. 5 is a flowchart illustrating an example of a processing procedure regarding a first process.
FIG. 6 is a flowchart illustrating an example of a processing procedure regarding an extraction process.
FIG. 7 is a flowchart illustrating an example of a processing procedure regarding a second process.
FIG. 8 is a schematic diagram illustrating an example of a screen showing an estimation result of a degradation state.
FIG. 9 is a flowchart illustrating an example of a processing procedure to be executed by an information processing apparatus according to a third embodiment.
FIG. 10 is a flowchart illustrating an example of a processing procedure to be executed by an information processing apparatus according to a fourth embodiment.

### DESCRIPTION OF EMBODIMENTS

(1) An information processing method according to an aspect of the present disclosure includes: acquiring measurement data of a plurality of energy storage devices; executing, based on measurement data of a first energy storage device group selected from the plurality of energy storage devices, a first process for estimating a degradation state of the first energy storage device group; extracting, from among the plurality of energy storage devices, a second energy storage device to be subjected to a second process; and executing, based on measurement data of the extracted second energy storage device, a second process for estimating a degradation state of the second energy storage device.

According to the information processing method described in (1) above, for the measurement data of the plurality of energy storage devices provided in a large-scale energy storage system, the degradation state can be estimated constantly as the first process by using the measurement data of the first energy storage device group, and the degradation state can be estimated non-constantly as the second process by using the measurement data of the second energy storage device. The second energy storage device is extracted by a predetermined extraction process, and may be, for example, an energy storage device having a possibility of abnormality. An enormous amount of measurement data regarding numerous energy storage devices obtained from a large-scale energy storage system is organized and distributed in accordance with their characteristics and monitoring purposes (processing purposes), and processing based on the measurement data is executed, whereby the measurement data can be efficiently and effectively utilized. The degradation state of an energy storage device can be accurately monitored while suppressing an increase in a processing load of measurement data related to a large-scale energy storage system.

In the information processing method, the state of the entire energy storage device system can be comprehensively observed by the first process on the first energy storage device group. In addition, by additionally executing a state analysis of the energy storage device exhibiting a behavior deviating from the group by the second process on the second energy storage device, it is possible to prevent, for example, missed detection of abnormality. Alternatively, it is possible to confirm and observe a degradation state of an energy storage device which degrades faster than other energy storage devices. Accordingly, it is possible to timely notify a system/service provider, a manager, and a user of the status of the energy storage system. It is possible to prepare for maintenance of the system, such as a sign of a malfunction or a timing at which the energy storage device is to be replaced, and to take an appropriate action in a timely manner. By appropriately extracting the measurement data on which predetermined processing is to be executed and efficiently processing the measurement data, it is possible to suitably monitor the state of the large-scale energy storage system.

The degradation state may be, for example, a state of health (SOH) of the energy storage device, or may be information such as an internal resistance, a charge/discharge characteristic, an energy storage capacity, a degradation amount of the energy storage capacity (for example, an energization degradation amount and a non-energization degradation amount), degradation rates of a positive electrode and a negative electrode, a deviation in capacity balance (a difference in capacity in which charge ions can reversibly enter and exit from an electrode between a positive electrode and a negative electrode of the energy storage device), a geometric shape of the energy storage device, and a function of the energy storage device under a predetermined load and temperature situation, such as a state of function (SOF). The first process and the second process may include abnormality detection for detecting abnormality of the energy storage device based on an estimation result of the degradation state.

(2) In the information processing method described in (1) above, when an abnormality of the first energy storage device group or the second energy storage device is detected based on an estimation result from the first process or the second process, warning information may be output.

According to the information processing method described in (2) above, by outputting the warning information, it is possible to reliably notify, for example, an operator of abnormality of the energy storage device. By executing an analysis process on an energy storage device suitably extracted from an enormous amount of data, it is possible to prevent abuse of warning information and suitably provide information to be notified.

(3) In the information processing method described in (1) or (2) above, proposal information regarding an operation of the plurality of energy storage devices may be generated based on an estimation result from the first process or the second process.

According to the information processing method described in (3) above, since it is possible to easily grasp an operation method for an abnormality of an energy storage device, it is possible to quickly cope with the abnormality. The proposal information may include, for example, information prompting review of a load or an environment of a large-scale energy storage system including a plurality of energy storage devices, or replacement of an energy storage device.

(4) In the information processing method described in any one of (1) to (3) above, the first process or the second process may include a process for estimating a current degradation state and a process for estimating a future degradation state.

According to the information processing method described in (4) above, it is possible to grasp a sign of an abnormality in a future degradation state, in addition to a current abnormality of the energy storage device. In addition, it becomes possible to isolate a cause of abnormality when an abnormality is detected in the state of the energy storage device. For example, a case is assumed in which the estimation of the current degradation state is an estimation method in consideration of the internal state of the energy storage device from the latest measurement data, and the estimation of the future degradation state is an estimation method in consideration of the influence of the load or the environment on the energy storage device. When the current degradation state is abnormal, it can be classified as being due to the internal state of the energy storage device, and when the future degradation state is worse than assumed and is abnormal, it can be classified as being due to the load or environment of the energy storage device.

(5) In the information processing method in any one of (1) to (4) above, a distribution of measurement data in the plurality of energy storage devices may be acquired, and the second energy storage device may be extracted based on the acquired distribution of the measurement data.

According to the information processing method described in (5) above, it is possible to efficiently and accurately specify an energy storage device exhibiting a behavior deviating from the group, based on a distribution of measurement data, which is relatively easy to calculate. The measurement data for acquiring the distribution may be, for example, a voltage value. Even when the second energy storage device is extracted from among a large number of energy storage devices, a calculation cost can be reduced, and high-speed processing can be performed. By executing the second process with a high calculation cost on the second energy storage device extracted by a high-speed and simple abnormality detection process, the degradation state can be estimated efficiently and accurately. By processing in two stages, misdetection factors can be reduced, and the false positive rate can be lowered.

(6) In the information processing method described in any one of (1) to (5) above, a voltage distribution in the plurality of energy storage devices may be acquired based on the measurement data of the plurality of energy storage devices, and an energy storage device in which a difference from an average value or a median value of voltages calculated based on the acquired voltage distribution is greater than or equal to a predetermined value may be extracted as the second energy storage device.

According to the information processing method described in (6) above, by focusing on the voltage that suitably reflects the state of the energy storage device, and using the voltage difference indicating a variation from the average value as an evaluation index, it is possible to accurately specify the second energy storage device having a possibility of abnormality.

(7) In the information processing method described in any one of (1) to (6) above, any one energy storage device of the first energy storage device group may be extracted as the second energy storage device, based on an estimation result from the first process.

According to the information processing method described in (7) above, since the second process can be further executed for an energy storage device with an abnormal degradation state obtained by the first process, it is possible to more reliably grasp the state of the energy storage device.

(8) In the information processing method described in any one of (1) to (7) above, the first energy storage device group may be selected based on a distribution of loads or temperatures of the plurality of energy storage devices.

According to the information processing method described in (8) above, by selecting the first energy storage device group in consideration of the load or the temperature that strongly affects the degradation state of the energy storage device, it is possible to suitably grasp a representative behavior of the energy storage device system. The first energy storage device group may include, for example, an energy storage device corresponding to a maximum value, a minimum value, or an average value of the load or temperature in each unit when the large-scale energy storage system is divided into specific units. In particular, it is desirable to set, as one unit, a group of energy storage devices of the same battery type and coupled in the same series path. According to the above configuration, it is possible to suitably select an energy storage device that represents the distribution of the degradation state.

(9) In the information processing method described in any one of (1) to (8) above, the first process may be executed based on the measurement data in a first period, and the second process may be executed based on the measurement data in a second period excluding a specific period in the first period.

According to the information processing method described in (9) above, details of the measurement data to be processed can be made different between the first process and the second process. For example, in the second process, by removing irregular measurement data in an initial stage of operation, measurement data in a non-energization period, measurement data related to a distinctive usage history, or the like, it becomes possible to estimate in line with an actual usage state of the energy storage device under normal circumstances.

(10) In the information processing method described in any one of (1) to (9) above, the number of the plurality of energy storage devices may be one million or more.

According to the information processing method described in (10) above, it is possible to more suitably process a large amount of measurement data collected particularly in units of several millions.

(11) An information processing system according to an aspect of the present disclosure includes: an acquisition unit that acquires measurement data of a plurality of energy storage devices; a first processing unit that executes, based on measurement data of a first energy storage device group selected from the plurality of energy storage devices, a first process for estimating a degradation state of the first energy storage device group; an extraction unit that extracts, from among the plurality of energy storage devices, a second energy storage device to be subjected to a second process; and a second processing unit that executes, based on measurement data of the extracted second energy storage device, a second process for estimating a degradation state of the second energy storage device.

(12) A program according to an aspect of the present disclosure causes a computer to execute processes of: acquiring measurement data of a plurality of energy storage devices; executing, based on measurement data of a first energy storage device group selected from the plurality of energy storage devices, a first process for estimating a degradation state of the first energy storage device group; extracting, from among the plurality of energy storage devices, a second energy storage device to be subjected to a second process; and executing, based on measurement data of the extracted second energy storage device, a second process for estimating a degradation state of the second energy storage device.

Hereinafter, the present disclosure will be specifically explained with reference to the drawings illustrating embodiments thereof.

### (First Embodiment)

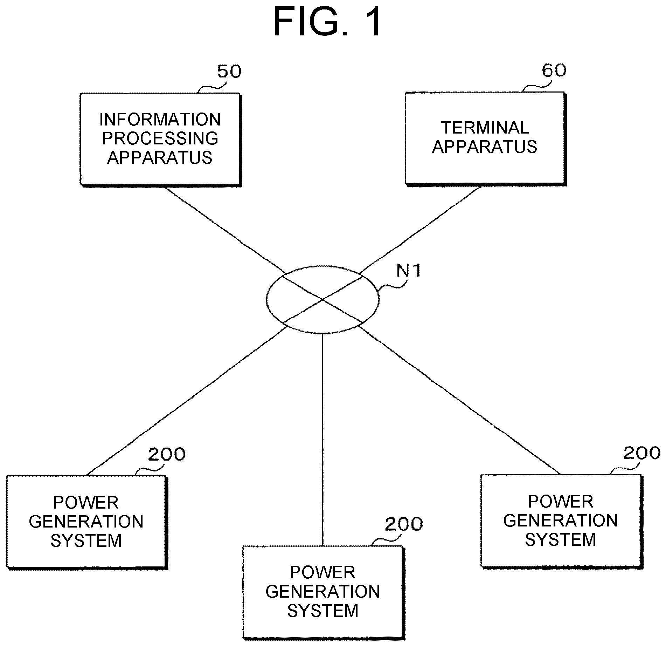

FIG. 1 is a diagram illustrating an overview of a remote monitoring system (information processing system) 100 according to an embodiment. The remote monitoring system 100 enables remote access to information regarding energy storage devices included in a power generation system 200. The remote monitoring system 100 includes an information processing apparatus 50 as a main apparatus. The information processing apparatus 50 collects information from the power generation system 200 to be remotely monitored. The information processing apparatus 50 is connected to a network N1 such as the Internet. Further, a terminal apparatus 60 and the power generation system 200 are connected to the network N1.

The information processing apparatus 50 and the terminal apparatus 60 are not limited to separate apparatuses, and for example, the information processing apparatus 50 and the terminal apparatus 60 may be one common processing apparatus. The information processing apparatus 50 and the terminal apparatus 60, or one of the apparatuses, may be integrated into any of the power generation systems 200. The number of power generation systems 200 may be one, or three or more.

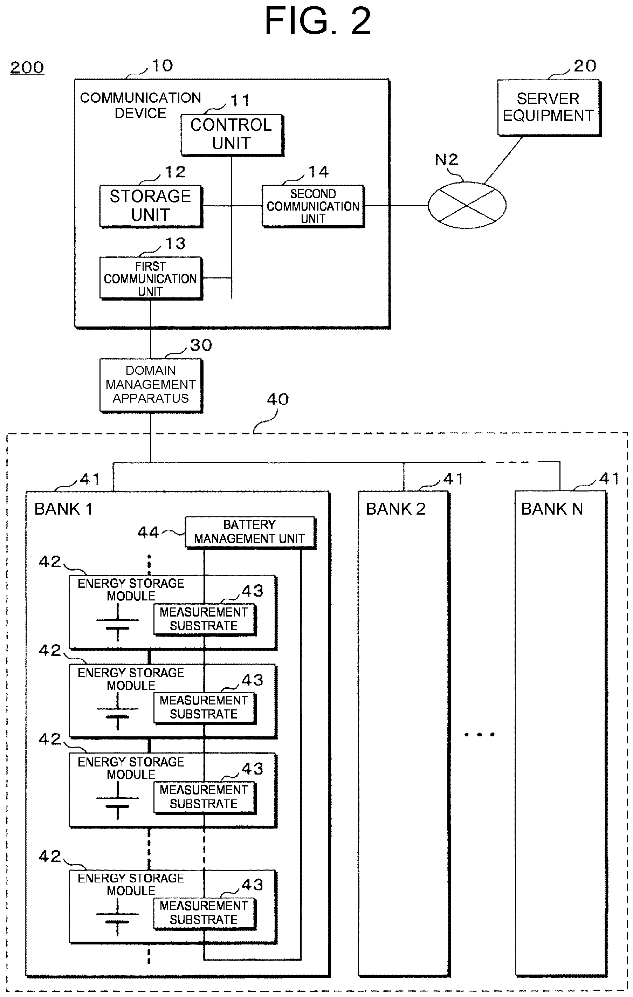

FIG. 2 is a block diagram illustrating a configuration example of the power generation system 200. Illustration of a power generation apparatus such as a solar power generation system or a wind power generation system is omitted. The power generation system 200 includes a communication device 10, a domain management apparatus 30, and an energy storage unit (domain) 40. The server equipment 20 is connected to the communication device 10 via a network N2. The energy storage unit 40 may include a plurality of banks 41. The energy storage unit 40 is accommodated in, for example, a battery panel, and is used in a thermal power generation system, a mega solar power generation system, a wind power generation system, an uninterruptible power supply (UPS), a stabilized power supply system for railway, or the like. A configuration including the communication device 10, the domain management apparatus 30, and the energy storage unit 40 is referred to as an energy storage system. The energy storage system may include a power conditioner which is not illustrated. The energy storage unit 40 is not limited to industrial applications, and may be for home use. The power generation system 200 corresponds to a large-scale energy storage system including a plurality of energy storage devices.

A business operator performs a business of designing, introducing, operating, and maintaining an energy storage system including the communication device 10, the domain management apparatus 30, and the energy storage unit 40, and can remotely monitor the energy storage system using the remote monitoring system 100.

The communication device 10 includes a control unit 11, a storage unit 12, a first communication unit 13, and a second communication unit 14. The control unit 11 is constituted by a central processing unit (CPU) or the like, and controls the entire communication device 10 by using a built-in memory such as a read only memory (ROM) and a random access memory (RAM).

The storage unit 12 includes, for example, a non-volatile storage device such as a flash memory. The storage unit 12 can store required information, and can store, for example, information acquired through processing by the control unit 11.

The first communication unit 13 includes a communication interface that achieves communication with the domain management apparatus 30 or the battery management unit 44. The control unit 11 can communicate with the domain management apparatus 30 through the first communication unit 13.

The second communication unit 14 includes a communication interface that achieves communication via the network N2. The control unit 11 can communicate with the server equipment 20 through the second communication unit 14.

The domain management apparatus 30 transmits and receives information to and from each bank 41 by using a predetermined communication interface. The storage unit 12 can store therein the measurement data acquired via the domain management apparatus 30.

The server equipment 20 can collect measurement data of the energy storage system from the communication device 10. The measurement data includes measured values such as a current, a voltage, and a temperature of each energy storage device in the energy storage system. The server equipment 20 may classify and store the collected measurement data for each energy storage device. The server equipment 20 can transmit the measurement data to the information processing apparatus 50 via the networks N2 and N1. Note that the networks N1 and N2 may be a single communication network.

The bank 41 is formed by connecting a plurality of energy storage modules in series, and includes a battery management unit (BMU) 44, a plurality of energy storage modules 42, a measurement substrate (CMU: Cell Management Unit) 43 provided in each of the energy storage modules 42, and the like.

In the energy storage module 42, a plurality of energy storage cells are connected in series. In the present specification, the "energy storage device" may mean an energy storage cell, the energy storage module 42, the bank 41, or a domain in which the banks 41 are connected in parallel. In the present embodiment, the measurement substrate 43 acquires measurement data regarding each energy storage cell of the energy storage module 42. The measurement data can be repeatedly acquired at an appropriate period such as 0.1 seconds, 0.5 seconds, or 1 second, for example. The "energy storage device" is preferably a rechargeable energy storage device, such as a secondary battery, e.g., a lead-acid storage battery or a lithium-ion battery, or a capacitor. A part of the energy storage devices may be a non-rechargeable primary battery.

The battery management unit 44 can communicate with the measurement substrate 43 with a communication function by serial communication, and can acquire measurement data detected by the measurement substrate 43. The battery management unit 44 can transmit and receive information to and from the domain management apparatus 30. The domain management apparatus 30 aggregates the measurement data from the battery management units 44 of the banks belonging to the domain. The domain management apparatus 30 outputs the aggregated measurement data to the communication device 10. As described above, the communication device 10 can acquire and store the measurement data of the energy storage unit 40 via the domain management apparatus 30.

The communication device 10 transmits the measurement data, which has been stored from the previous timing onwards, to the server equipment 20 at a predetermined timing (for example, at a constant period, or when a data amount satisfies a predetermined condition, etc.). The measurement data may be associated with identification information of the energy storage device.

The information processing apparatus 50 according to the present embodiment uses measurement data of a plurality of energy storage devices provided in the power generation system 200, thereby executing an analysis process, such as estimation of a degradation state of the energy storage device and abnormality detection, and monitors the state of the power generation system 200. The information processing apparatus 50 presents a result of the analysis process to a user or an operator (a person in charge of maintenance) through the terminal apparatus 60.

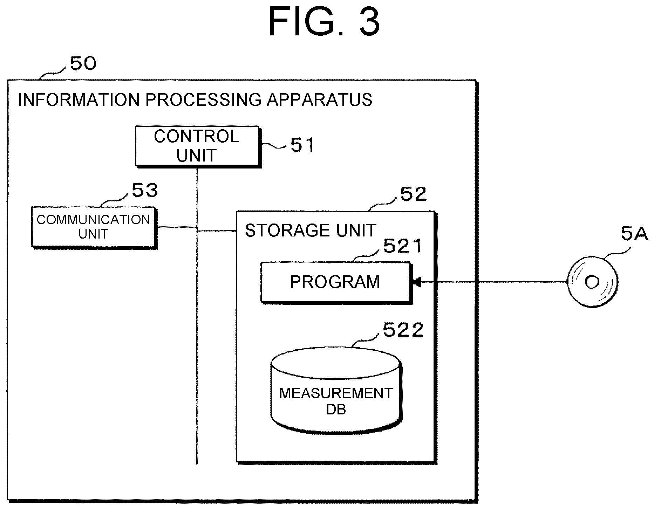

FIG. 3 is a block diagram illustrating a configuration example of the information processing apparatus 50. The information processing apparatus 50 is, for example, a server computer, a personal computer, a quantum computer, or the like, and performs various kinds of information processing and transmission/reception of information. The information processing apparatus 50 may be a multi-computer including a plurality of computers, or may be a virtual machine virtually constructed by software. The information processing apparatus 50 includes a control unit 51, a storage unit 52, and a communication unit 53.

The control unit 51 is an arithmetic circuit including a CPU, a graphics processing unit (GPU), a ROM, a RAM, and the like. The CPU or the GPU included in the control unit 51 executes various computer programs stored in the ROM or the storage unit 52, and controls an operation of each of the above-described hardware units. The control unit 51 may include functions such as a timer that measures an elapsed time from when a measurement start instruction is given to when a measurement end instruction is given, a counter that counts the number, and a clock that outputs date and time information.

The storage unit 52 includes a non-volatile storage device such as a flash memory or a hard disk drive. The storage unit 52 stores therein various computer programs, data, and the like to be referred to by the control unit 51. The storage unit 52 may be an external storage device connected to the information processing apparatus 50.

The storage unit 52 according to the present embodiment stores a program 521 for causing a computer to execute a process regarding estimation of a degradation state of an energy storage device, and a measurement data base (DB) 522 as data necessary for execution of the program 521.

The measurement DB 522 is a data base that stores therein measurement data received from the power generation system 200. As described above, the measurement data includes the measured values of the current, the voltage, and the temperature of the energy storage device in the power generation system 200. The measurement data of the voltage, the current, and the temperature includes data during charge or discharge of the energy storage device. In the measurement DB 522, for example, a record in which information such as identification information of an energy storage device, a measurement date and time, and measurement data is associated with an ID for identifying the measurement data as a key is stored in time series order. The measurement DB 522 may further store, for example, information regarding the arrangement of energy storage devices, a degradation state obtained by an estimation process to be described below, a result of abnormality detection, and the like. Every time the control unit 51 receives the measurement data transmitted from the server equipment 20 at an appropriate timing, the control unit 51 stores the received measurement data in the measurement DB 522 in time series order.

The storage unit 52 may also store identification information of each energy storage device included in a first energy storage device group to be described below, various threshold values for analysis processing, and the like.

A computer program (program product) including the program 521 may be provided by a non-transitory recording medium 5A in which the computer program is recorded in a readable manner. The recording medium 5A is a portable memory such as a CD-ROM, a USB memory, or a secure digital (SD) card. The control unit 51 reads a desired computer program from the recording medium 5A by using a reading device not illustrated, and stores the read computer program in the storage unit 52. Alternatively, the above-described computer program may be provided by communication. The program 521 may be constituted by a single computer program or a plurality of computer programs, and may be executed on a single computer or on a plurality of computers interconnected by a communication network.

The communication unit 53 includes a communication interface that achieves communication via the network N1. The control unit 51 receives the measurement data transmitted from the power generation system 200, through the communication unit 53. The control unit 51 transmits various processing results to an external apparatus such as the terminal apparatus 60, via the communication unit 53.

The information processing apparatus 50 may include a display unit that displays various pieces of information, an operation unit that receives a user's operation, and the like.

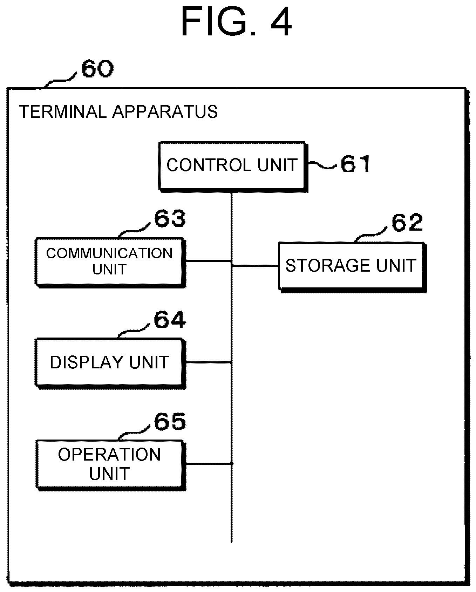

FIG. 4 is a block diagram illustrating a configuration example of the terminal apparatus 60. The terminal apparatus 60 may be a computer to be used by an operator such as a manager or a maintenance person of a storage battery system of the power generation system 200. The terminal apparatus 60 is, for example, a personal computer, a smartphone, a tablet terminal, or the like, and is an information terminal apparatus that performs various kinds of information processing and transmission/reception of information. The terminal apparatus 60 includes a control unit 61, a storage unit 62, a communication unit 63, a display unit 64, an operation unit 65, and the like.

The control unit 61 is an arithmetic circuit including a CPU, a ROM, a RAM, and the like. The CPU or a GPU included in the control unit 61 executes various computer programs stored in the ROM or the storage unit 62, and controls an operation of each of the above-described hardware units.

The storage unit 62 includes a non-volatile storage device such as a flash memory or a hard disk drive. The storage unit 62 stores therein various computer programs, data, and the like to be referred to by the control unit 61. The control unit 61 causes the display unit 64 to display various processing results provided by the information processing apparatus 50, based on the computer program stored in the storage unit 62.

The communication unit 63 includes a communication interface that achieves communication via the network N1. The control unit 61 transmits and receives information to and from the information processing apparatus 50 via the communication unit 63.

The display unit 64 includes, for example, a display device such as a liquid crystal display or an organic electro luminescence (EL) display. The display unit 64 displays information to be notified to the user in accordance with an instruction from the control unit 61. The display unit 64 may be interpreted as a notification unit, and may be a means for notifying the user by other means such as voice.

The operation unit 65 is an interface that receives an operation by a user. The operation unit 65 includes, for example, a keyboard, a touch panel device with a built-in display, a speaker, a microphone, and the like. The operation unit 65 receives an operation input from a user, and transmits a control signal corresponding to the operation content to the control unit 61.

The information processing apparatus 50 efficiently selects, from among a large number of energy storage devices in the power generation system 200, a specific energy storage device that exhibits a behavior deviating from a group, and executes degradation state estimation and abnormality detection on the measurement data of the selected energy storage device.

In the present embodiment, the information processing apparatus 50 selects, in advance, a first energy storage device group representing a distribution of electric power or temperature, with respect to electric power or temperature, which greatly affects a degradation state, among measurement indices. The information processing apparatus 50 executes a first process for estimating a degradation state of the selected first energy storage device group. In addition, the information processing apparatus 50 executes an extraction process of extracting a second energy storage device having an abnormal voltage value, based on a voltage distribution of the acquired measurement data, with respect to voltages indicating varied changes among the measurement indices. The information processing apparatus 50 additionally executes a second process for estimating a degradation state of the extracted second energy storage device.

As described above, the information processing apparatus 50 constantly executes an analysis process on the first energy storage device group representing the power (load) or the temperature (environment) in the power generation system 200, and the extraction process corresponding to simple abnormality detection based on the voltage distribution. Further, an analysis process on the second energy storage device extracted by the simple abnormality detection is executed in a non-constantly manner. The information processing apparatus 50 achieves efficient and effective data processing by organizing and distributing measurement data in accordance with a characteristic of the measurement data and a monitoring purpose (processing purpose), and selectively executing the process. Hereinafter, an operation of the information processing apparatus 50 will be explained.

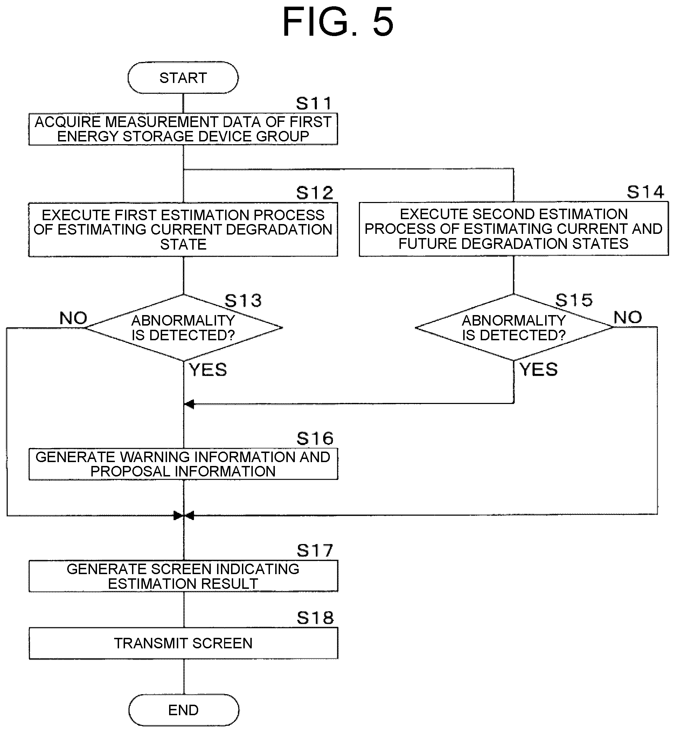

FIG. 5 is a flowchart illustrating an example of a processing procedure regarding the first process. The processing in each flowchart described below may be executed by the control unit 51 in accordance with a program 5P stored in the storage unit 52 of the information processing apparatus 50, may be achieved by a dedicated hardware circuit (for example, an FPGA or an ASIC) provided in the control unit 51, or may be achieved by a combination thereof. The information processing apparatus 50 repeatedly executes the following processes at predetermined or appropriate intervals. The information processing apparatus 50 preferably processes the measurement data measured by the power generation system 200 in real time.

The control unit 51 of the information processing apparatus 50 acquires (extracts), by the function as the acquisition unit, the measurement data of the first energy storage device group among the plurality of energy storage devices included in the power generation system 200, based on the information stored in the measurement DB 522 (Step S11). Alternatively, the control unit 51 may acquire the measurement data of the first energy storage device group by communication with the server equipment 20.

The first energy storage devices included in the first energy storage device group may be selected in advance in accordance with a predetermined rule, or may be selected manually, for example. As an example, the first energy storage device group may include an energy storage device corresponding to a maximum value or a minimum value of loads or temperatures in each unit when the power generation system 200 is divided into specific units (for example, for each bank). The load corresponds to a current of the energy storage device or electric power calculated based on the current. The first energy storage device group may further include an energy storage device corresponding to an average value of loads or temperatures in each unit. The load or the temperature of the energy storage device may be obtained by acquiring actual measurement data at an initial stage of measurement, or may be a predicted value based on the arrangement of the energy storage devices in the power generation system 200. The number of energy storage devices in the first energy storage device group can be determined in consideration of the total number of energy storage devices in the power generation system 200.

The first energy storage device may be changed in the middle of the processing period. For example, when an energy storage device different from the selected first energy storage device is specified to correspond to the maximum value of the temperature, based on the measurement data collected in a time-dependent manner, the different energy storage device can be set as a new first energy storage device.

The control unit 51 executes a first process including a first estimation process and a second estimation process by the function as the first processing unit. The control unit 51 executes a first estimation process of estimating a current degradation state of each first energy storage device included in the first energy storage device group by a first estimation method (Step S12). Hereinafter, a case where the SOH is estimated as the degradation state will be explained as an example.

As the first estimation process, the control unit 51 estimates a current SOH of the first energy storage device, based on the acquired measurement data of the first energy storage device. The control unit 51 may estimate the current SOH by using the measurement data for the most recent short period, among the measurement data for the entire period from the start of measurement to the present.

The first estimation method is not particularly limited as long as the degradation state is calculated in consideration of the internal state of the energy storage device. As an example, the control unit 51 derives an energy storage amount-voltage curve (charge/discharge characteristic), and estimates the current SOH, based on the derived charge/discharge characteristic.

The control unit 51 calculates time series data of a quantity of electricity (energy storage amount), based on short-term current and voltage time-series data of the first energy storage device, and generates an energy storage amount-voltage curve indicating a relationship between the calculated energy storage amount and a voltage corresponding to the energy storage amount. The control unit 51 complements a capacity band in which no measurement data is obtained in the generated energy storage amount-voltage curve, by using a quantity of electricity obtained from a difference between the positive electrode single-electrode characteristic and the negative electrode single-electrode characteristic. Accordingly, an energy storage amount-voltage curve from a lower limit voltage value to an upper limit voltage set for the energy storage device is obtained. A current energy storage capacity and an SOH are obtained by subtracting the energy storage amount corresponding to the upper limit voltage from the energy storage amount corresponding to the lower limit voltage of the charge/discharge characteristic. The charge/discharge characteristic may be an SOC-voltage curve based on the SOC and voltage corresponding to the energy storage amount.

Alternatively, the control unit 51 may obtain the SOH by acquiring an actual capacity measured by performing full charge and discharge from a lower limit voltage value to an upper limit voltage set for the energy storage device, or may calculate the energy storage capacity by measuring an internal resistance of the energy storage device.

The control unit 51 performs abnormality detection of the first energy storage device, based on an estimation result of the first estimation process (Step S13). In Step S13, the control unit 51 executes a determination process of determining whether or not each first energy storage device is abnormal. Specifically, the control unit 51 compares the current SOH of the first energy storage device obtained by the first estimation process with a reference degradation state, thereby determining whether or not the current SOH of the first energy storage device is abnormal.

The control unit 51 calculates a difference between the current SOH of the first energy storage device and the reference SOH (reference degradation state), and determines whether or not the calculated difference is greater than or equal to a threshold value set in advance. In the present specification, the "difference" means an absolute value of the difference. When the difference is greater than or equal to the threshold value, the control unit 51 determines that the first energy storage device is abnormal. When the difference is less than the threshold value, the control unit 51 determines that the first energy storage device is normal.

When the charge/discharge characteristic of the first energy storage device is obtained, the control unit 51 may compare the charge/discharge characteristic of the first energy storage device with the reference charge/discharge characteristic. The control unit 51 performs abnormality detection, based on a difference between the SOH specified from the charge/discharge characteristic of the first energy storage device and the reference SOH specified from the reference charge/discharge characteristic. Alternatively, curve shapes of the charge/discharge characteristic of the first energy storage device and the reference charge/discharge characteristic may be compared. The control unit 51 may perform abnormality detection by determining whether or not an amount of deviation of the curved shape in an axial direction of the energy storage capacity is greater than or equal to a predetermined value, or whether or not a degree of similarity of the curved shape is less than a predetermined value, or the like.

The reference charge/discharge characteristic may be generated in advance and stored in the storage unit 52, or may be generated based on measurement data of a normal energy storage device installed around each first energy storage device, the energy storage device having an environment or a usage history that is the same as or similar to that of the first energy storage device.

The reference degradation state may be a reference value of SOH set in advance. The control unit 51 performs abnormality detection by comparing the reference value of SOH set in advance with the SOH of the first energy storage device calculated from the above-described charge/discharge characteristic or the SOH of the first energy storage device obtained by an other method. The reference degradation state may also be a reference value regarding an energy storage capacity, an internal resistance, or a change amount thereof.

When it is determined that the first energy storage device is abnormal (an abnormality of the first energy storage device is detected) by determining that any of the first energy storage devices is abnormal (Step S13: YES), the control unit 51 advances the process to Step S16. When it is determined that the first energy storage device is not abnormal (no abnormality of the first energy storage device is detected) by determining that all the first energy storage devices are normal (Step S13: NO), the control unit 51 advances the process to Step S17.

In parallel with the above-described first estimation process, the control unit 51 executes a second estimation process of estimating the current and future degradation states of each first energy storage device by a second estimation method (Step S14).

As the second estimation process, the control unit 51 estimates the current and future degradation states of each first energy storage device by using a life prediction simulator. The life prediction simulator can estimate (calculate) a degradation state of the energy storage device at the present time or at a certain time point in the future, using a current, a voltage, and a temperature of the energy storage device over a predetermined period as input data. A certain time point in the future, i.e., a life prediction target period, in the life prediction simulator can be appropriately set based on how far into the future the life is to be predicted. The control unit 51 may use, as input data, the measurement data of the first energy storage device for the entire period, which is stored in the measurement DB 522.

The life prediction simulator calculates degradation values of energization degradation and non-energization degradation by using the SOC of the energy storage device estimated based on the current data and the voltage data, and the temperature of the energy storage device estimated based on the temperature data. By sequentially calculating an integrated value of the energization degradation value and the non-energization degradation value, the SOH at a time point to be estimated is calculated.

When a future SOH is predicted, prediction data of a current, a voltage, and a temperature up to a future time point can be input to the life prediction simulator. The prediction data may be derived by predicting a time series pattern of electric power or current (load) and a time series pattern of environmental temperature when the first energy storage device is used in the same manner as before, based on actual measured values of the measurement data of the first energy storage device acquired up to the present, and conforming to these prediction results.

In the present embodiment, the control unit 51 predicts the current and future SOHs by using a life prediction simulator. Alternatively, the control unit 51 may predict only the future SOH by using the life prediction simulator.

The control unit 51 performs abnormality detection of the first energy storage device, based on the estimation result of the second estimation process (Step S15). In Step S15, the control unit 51 executes a determination process of determining whether or not each first energy storage device is abnormal. Specifically, the control unit 51 compares the current and future SOHs of the first energy storage device obtained by the second estimation process with reference values of the current and future SOHs, thereby determining whether or not the current and future SOHs of the first energy storage device are abnormal.

The control unit 51 calculates each of differences between the current and future SOHs of the first energy storage device and the reference values of the current and future SOHs, and determines whether or not each of the calculated differences is greater than or equal to a threshold value set in advance. When the difference is greater than or equal to the threshold value, the control unit 51 determines that the first energy storage device is abnormal. When the difference is less than the threshold value, the control unit 51 determines that the first energy storage device is normal. The control unit 51 determines whether or not each of the current and future SOHs is abnormal.

As the reference value of the SOH, a preset value may be stored in the storage unit 52, or may be calculated by the life prediction simulator using measurement data of a normal energy storage device installed around each first energy storage device, the energy storage device having an environment or a usage history that is the same as or similar to that of the first energy storage device.

An example in which the presence or absence of abnormality is determined based on the comparison of the SOHs has been explained above. Alternatively, the control unit 51 may determine the presence or absence of an abnormality in the first energy storage device or a load condition or temperature related to the first energy storage device, based on at least one of the load or the temperature. The control unit 51 compares, for example, a future load of the first energy storage device with a reference value of the future load. When an increase amount of the load of the first energy storage device with respect to the reference value of the future load is greater than or equal to a threshold value set in advance, the load condition for the first energy storage device may be determined to be abnormal. When a difference between a reference value of a current temperature and a temperature of the first energy storage device is greater than or equal to the threshold value, based on a comparison between the current temperature of the first energy storage device and the reference value of the current temperature, the control unit 51 may determine that the first energy storage device or ambient temperature environment of the first energy storage device is abnormal.

When it is determined that the first energy storage device is abnormal by determining that any of the first energy storage devices is abnormal (Step S15: YES), the control unit 51 advances the process to Step S16. When it is determined that the first energy storage device is not abnormal by determining that all the first energy storage devices are normal (Step S15: NO), the control unit 51 advances the process to Step S17.

The control unit 51 may execute the first estimation process and the second estimation process in parallel, or may execute one of the first estimation process and the second estimation process, and then execute the other.

When an abnormality of the energy storage device is detected, the control unit 51 generates warning information notifying the abnormality, and proposal information proposing an operation method of the power generation system 200 corresponding to the first energy storage device in which the abnormality is detected (Step S16). **In** the present embodiment, a configuration is adopted in which the warning information and proposal information are included in a screen indicating an estimation result to be described below.

The control unit 51 generates a screen indicating an estimation result of the degradation state of the first energy storage device group (Step S17). The estimation result includes the current and future SOH values of each first energy storage device. The control unit 51 transmits the generated screen to the terminal apparatus 60 (Step S18), and causes the screen to be displayed through the display unit 64 of the terminal apparatus 60. Alternatively, the control unit 51 may output the generated screen to an external computer or the like. By the above-described processes, the first process for estimating the degradation state of the first energy storage device group is ended.

An example in which warning information and proposal information are output by using the screen indicating the estimation result has been explained above. Alternatively, the control unit 51 may output the warning information and/or the proposal information separately from the screen indicating the estimation result. The control unit 51 may be configured not to output the estimation result when no abnormality is detected.

As described above, the information processing apparatus 50 executes two types of estimation processes, i.e., the first estimation process in consideration of the internal state of the energy storage device and the second estimation process in consideration of the load and the environment. When an abnormality is detected, it is possible to isolate a cause of abnormality, i.e., whether the abnormality is an abnormality inside the energy storage device or an abnormality in the load and the environment. By isolating the cause of abnormality, it is possible to take appropriate measures in response to the cause of abnormality.

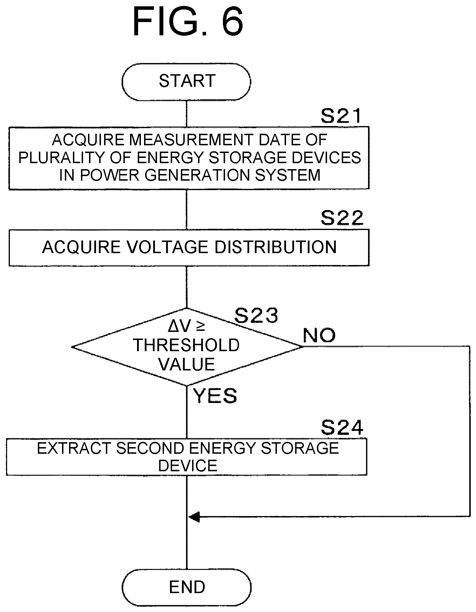

FIG. 6 is a flowchart illustrating an example of a processing procedure regarding the extraction process. The control unit 51 of the information processing apparatus 50 may execute the following processes after the processes in the flowchart of FIG. 5 ends, or may execute the following processes in parallel with the processes in the flowchart of FIG. 5.

The control unit 51 of the information processing apparatus 50 acquires the measurement data of the plurality of energy storage devices included in the power generation system 200, based on the information stored in the measurement DB 522 (Step S21). Alternatively, the control unit 51 may acquire the measurement data of each energy storage device by communication with the server equipment 20. **In** Step S21, the control unit 51 may acquire measurement data of all the energy storage devices included in the power generation system 200, or may acquire the measurement data of an energy storage device selected from among all the energy storage devices at random or in accordance with a predetermined rule. When the measurement data of all the energy storage devices is acquired, distribution information may be substituted by a statistical value such as a maximum value or a minimum value, for example.

The control unit 51 acquires a voltage distribution of the plurality of energy storage devices, based on the voltage in the acquired measurement data of the plurality of energy storage devices (Step S22), and specifies a maximum or minimum voltage value, based on the voltage distribution. The control unit 51 may divide the power generation system 200 into specific units (for example, for each bank), and acquire the voltage distribution for each divided unit.

The control unit 51 calculates a difference ΔV between the specified maximum or minimum voltage value and an average or a median voltage value calculated from the voltage distribution, and determines whether or not the calculated difference ΔV is greater than or equal to a threshold value set in advance (Step S23). When it is determined that the calculated difference ΔV is less than the threshold value set in advance (Step S23: NO), the control unit 51 determines that there is no second energy storage device to be extracted, and ends the extraction process.

When the calculated difference ΔV is greater than or equal to the threshold value set in advance (Step S23: YES), the control unit 51 extracts, as a second energy storage device, an energy storage device corresponding to a voltage value for which the difference ΔV greater than or equal to the threshold value has been calculated (Step S24). The control unit 51 functions as an extraction unit. By the above-described extraction process, it is possible to easily extract an energy storage device having a possibility of abnormality. The number of second energy storage devices extracted by the control unit 51 may be plural.

It is possible to efficiently and accurately specify a second energy storage device having a possibility of abnormality by focusing on, particularly, a voltage that suitably reflects a state of an energy storage device in a measurement data distribution that is relatively easy to calculate, and by using a voltage difference indicating a variation from the mean value as an evaluation index.

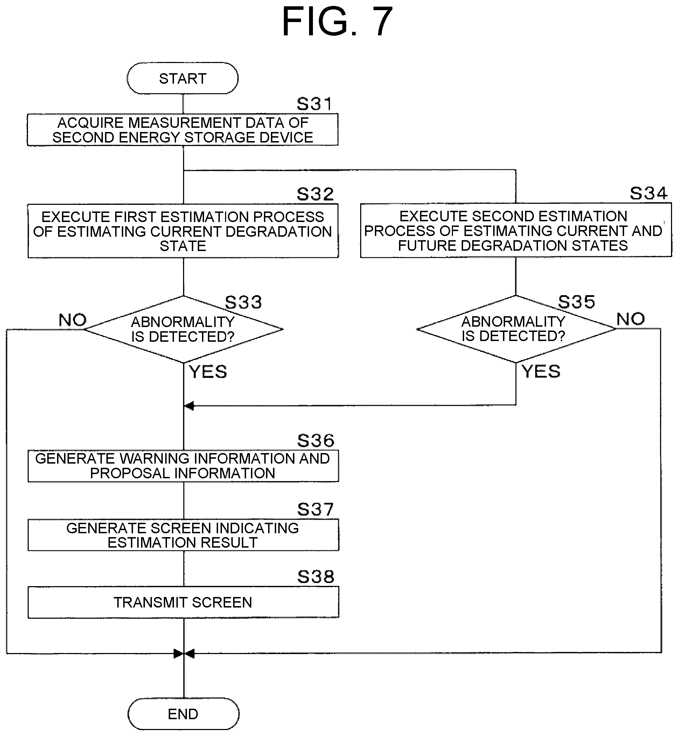

FIG. 7 is a flowchart illustrating an example of a processing procedure regarding the second process. After the processes in the flowchart of FIG. 6 ends, the control unit 51 of the information processing apparatus 50 executes the following processes.

The control unit 51 of the information processing apparatus 50 acquires measurement data of each of the extracted second energy storage devices, based on an extraction result of the second energy storage device and the information stored in the measurement DB 522 (Step S31).

The control unit 51 executes a second process including a first estimation process and a second estimation process by the function as a second processing unit. The control unit 51 executes, on each second energy storage device, a first estimation process of estimating a current degradation state, by a first estimation method (Step S32).

By the function as an abnormality detection unit, the control unit 51 performs abnormality detection of the second energy storage device, based on an estimation result of the first estimation process (Step S33). In Step S33, the control unit 51 executes a determination process of determining whether or not each second energy storage device is abnormal. Contents of the first estimation process and the abnormality detection process to be executed in the second process are the same as those of the first estimation process and the abnormality detection process in the first process explained in Steps S12 to S13 of the flowchart illustrated in FIG. 5, except that the processing target is the second energy storage device, and therefore, a detailed explanation thereof will be omitted.

When it is determined that the second energy storage device is abnormal by determining that any of the second energy storage devices is abnormal (Step S33: YES), the control unit 51 advances the process to Step S36. When it is determined that the second energy storage device is not abnormal by determining that all the second energy storage devices are normal (Step S33: NO), the control unit 51 ends the process. Alternatively, the control unit 51 may advance the process to Step S37.

In parallel with the above-described first estimation process, the control unit 51 executes, on each second energy storage device, a second estimation process of estimating current and future degradation states by a second estimation method (Step S34).

By the function as the abnormality detection unit, the control unit 51 performs abnormality detection of the second energy storage device, based on the estimation result of the second estimation process (Step S35). In Step S35, the control unit 51 executes a determination process of determining whether or not each second energy storage device is abnormal. Contents of the second estimation process and the abnormality detection process to be executed in the second process are the same as those of the second estimation process and the abnormality detection process in the first process explained in Steps S14 to S15 of the flowchart illustrated in FIG. 5, except that the processing target is the second energy storage device, and therefore, a detailed explanation thereof will be omitted.

When it is determined that the second energy storage device is abnormal by determining that any of the second energy storage devices is abnormal (Step S35: YES), the control unit 51 advances the process to Step S36. When it is determined that the second energy storage device is not abnormal by determining that all the second energy storage devices are normal (Step S35: NO), the control unit 51 ends the process. Alternatively, the control unit 51 may advance the process to Step S37.

When an abnormality of an energy storage device is detected, the control unit 51 generates warning information for notifying the abnormality and proposal information for proposing an operation method of the power generation system 200 corresponding to the first energy storage device in which the abnormality has been detected, to be output by using, for example, a screen to be described below (Step S36).

The control unit 51 generates a screen indicating an estimation result of the degradation state of the second energy storage device (Step S37). The estimation result includes current and future SOH values of the second energy storage device. The control unit 51 transmits the generated screen to the terminal apparatus 60 (Step S38), and causes the screen to be displayed through the display unit 64 of the terminal apparatus 60. By the above-described processes, the second process for estimating the degradation state of the second energy storage device is ended.

In the execution of the second process, the control unit 51 may receive an instruction to execute the second process from an operator. The operator selects, for example, only a desired second energy storage device from among the extracted second energy storage devices, and instructs to execute the second process. The control unit 51 executes the second process of the selected second energy storage device in response to the received execution instruction.

The control unit 51 may be configured to change the period of the measurement data to be processed in the execution of the first estimation process and/or the second estimation process according to the second process. For example, it is assumed that the control unit 51 executes the second estimation process according to the first process by using the measurement data of the first energy storage device for the entire period as an input to a life prediction simulator. In contrast to the above-described first process, the control unit 51 can execute the second estimation process according to the second process, with the measurement data of the second energy storage device in a period excluding a specific period from the entire period as an input to the life prediction simulator. The specific period may include, for example, a non-energization period in an initial stage of operation, a period indicating a distinctive usage history, and the like. The specific period may be acquired by receiving designation by the operator, for example, in the above-described reception of the execution instruction.

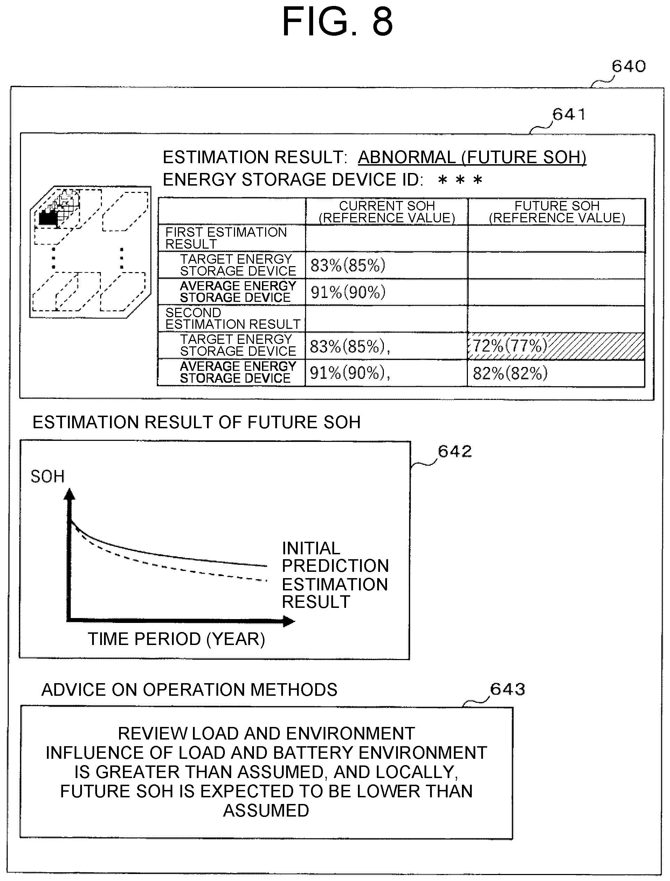

FIG. 8 is a schematic diagram illustrating an example of a screen indicating an estimation result of a degradation state. Hereinafter, an explanation will be given assuming that a screen 640 illustrated in FIG. 8 indicates the estimation result of the first process, but the same applies to an output example of the estimation result of the second process.

The screen 640 includes a result display portion 641 indicating an estimation result of a degradation state, a detail display portion 642 displaying details of the degradation state, and an advice display portion 643 displaying proposal information.

The result display portion 641 displays an estimation result of a degradation state of a first energy storage device to be displayed, in association with the information of the first energy storage device to be displayed as the estimation result. The estimation result includes the current SOH obtained by the first estimation process, and the current and future SOHs obtained by the second estimation process. For example, the information processing apparatus 50 generates, in accordance with identification information of each first energy storage device, an illustration indicating the position of the first energy storage device in the power generation system 200 in a recognizable manner, thereby displaying the first energy storage device to be displayed in an identifiable manner.

The information processing apparatus 50 causes the result display portion 641 to display, as an estimation result, SOHs estimated by the first estimation process and the second estimation process in association with a reference value (reference degradation information) for each SOH value. In FIG. 8, the degradation state of the first energy storage device to be displayed is displayed side by side together with the degradation state of an average energy storage device corresponding to the average load or temperature value included in the same bank as that of the first energy storage device to be displayed. The information processing apparatus 50 may display the estimation results of all the first energy storage devices in a list.

When there is an abnormality in the first energy storage device to be displayed, warning information is further displayed on the screen 640. The information processing apparatus 50 may cause text indicating that the SOH is abnormal to be displayed on the screen 640 as the warning information. The information processing apparatus 50 may display the SOH in which an abnormality has been detected in a recognizable manner by performing display process such as coloring, framing, or blinking on a value of the SOH in which an abnormality has been detected. In FIG. 8, warning information indicating an abnormality in the future SOH value is represented by hatching the future SOH in the result display portion 641.

The detail display portion 642 displays details of various processing results of the first energy storage device in which an abnormality has been detected, for example, by using a graph. When an abnormality of the first energy storage device is detected, the information processing apparatus 50 generates a graph corresponding to an abnormality content of the first energy storage device, and causes the detail display portion 642 to display the graph. As illustrated in FIG. 8, when the future SOH obtained by the second estimation process is abnormal, the information processing apparatus 50 generates a graph indicating a life prediction result of the first energy storage device. For ease of comparison, the information processing apparatus 50 may display a graph of the initial life prediction result or the reference value of the SOH in a superimposed manner on the graph indicating the generated life prediction result.

Alternatively, when the current SOH obtained by the first estimation process is abnormal, the information processing apparatus 50 may generate a graph indicating a charge/discharge characteristic of the first energy storage device. For ease of comparison, the information processing apparatus 50 may display a graph of the charge/discharge characteristic of the average energy storage device or the reference charge/discharge characteristic in a superimposed manner on the graph indicating the charge/discharge characteristic. When the screen 640 is a screen indicating an estimation result obtained by the second process, the information processing apparatus 50 may generate, as details of the result of the extraction process, a graph indicating a temporal change in the voltage difference ΔV.

The advice display portion 643 displays proposal information indicating operational advice corresponding to the degradation state of the first energy storage device. When generating the proposal information, the information processing apparatus 50 stores, for example, an advice table, which is not illustrated, in which the abnormality content and the operational advice are associated with each other in the storage unit 52 in advance. When an abnormality of the energy storage device is detected, the control unit 51 refers to the advice table, reads the proposal information in response to the abnormality content or the cause of abnormality, and causes the advice display portion 643 to display the proposal information.

When an abnormality is detected by the first estimation process, since the abnormality is caused by an internal state, replacement of the energy storage device is proposed as operational advice. When an abnormality is detected by the second estimation process, the abnormality is caused by a load or a temperature, and therefore, it is proposed to review the load or the environment (a temperature zone to be used) of the energy storage device as operational advice. The advice table may store advice in consideration of a divergence between the degradation state of the first energy storage device and the reference degradation state. For example, when the load of the first energy storage device in the degradation state is higher than that in the reference degradation state by a predetermined value or more, advice to propose to lower the load may be generated.

In a case where an abnormality is detected by the second estimation process, when a divergence between the current SOH obtained by the first estimation process and the current SOH obtained by the second estimation process exceeds the threshold value set in advance, replacement of the energy storage device may be proposed as the operational advice. When the divergence between the current SOH obtained by the first estimation process and the current SOH obtained by the second estimation process exceeds a predetermined value, it may be proposed to review an algorithm of the life prediction simulator as the operational advice. The review of the algorithm may be notified to the operator by an output mode such as alert information different from the operational advice.

According to the present embodiment, it is possible to accurately monitor a degradation state including future information while suppressing an increase in the processing load of an enormous amount of measurement data obtained from a large-scale energy storage system.

By executing the first process of efficiently estimating the current and future degradation states for the first energy storage device group selected in consideration of the load and temperature of the energy storage device, it becomes possible to perform abnormality detection that includes comprehensive isolation of causes of abnormality in the entire system. Further, by additionally executing the second process on the second energy storage device extracted in consideration of the voltage, it is possible to reduce missed detection of abnormality. By executing detailed abnormality detection by the second process on the second energy storage device extracted by the simple extraction process, it is possible to improve the accuracy of abnormality detection while reducing processing costs.

### (Second Embodiment)

In a second embodiment, a configuration in which a second energy storage device is extracted under an extraction condition different from the voltage distribution will be explained. Hereinafter, differences from the first embodiment will be mainly explained, and configurations common to those of the first embodiment will be denoted by the same reference numerals, and detailed explanations thereof will be omitted.

An information processing apparatus 50 according to the second embodiment extracts a second energy storage device, based on an estimation result of a first process. A control unit 51 of the information processing apparatus 50 receives an abnormality detection result for a current SOH obtained by a first estimation process and abnormality detection results for current and future SOHs obtained by a second estimation process. The control unit 51 extracts, based on the received abnormality detection result, a first energy storage device determined to be abnormal as the second energy storage device.

Alternatively, the control unit 51 may extract the second energy storage device to be subjected to a second process by, for example, statistical processing, a machine learning method, or a mathematical formula based on empirical rules for the measurement data of the plurality of energy storage devices. The control unit 51 may combine the plurality of extraction methods described above.

According to the present embodiment, the second energy storage device to be subjected to the second process can be extracted from a wider variety of viewpoints.

### (Third Embodiment)

In a third embodiment, a configuration for determining whether or not it is necessary to output warning information will be explained. Hereinafter, differences from the first embodiment will be mainly explained, and configurations common to those of the first embodiment will be denoted by the same reference numerals, and detailed explanations thereof will be omitted.

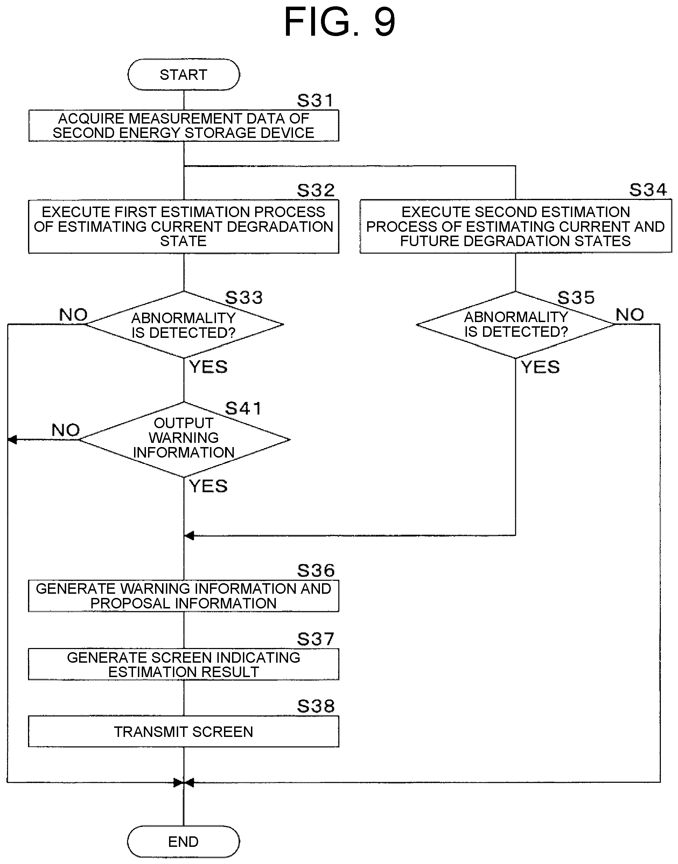

FIG. 9 is a flowchart illustrating an example of a processing procedure to be executed by an information processing apparatus 50 according to the third embodiment.

A control unit 51 of the information processing apparatus 50 executes a process in the same procedure as Steps S31 to S33 of the flowchart illustrated in FIG. 7, and detects an abnormality in a second energy storage device. When it is determined that a current SOH obtained by a first estimation process is abnormal (Step S33: YES), the control unit 51 determines whether or not to output warning information (Step S41). Specifically, the control unit 51 acquires a time variation in a difference between a current SOH of the second energy storage device and a reference SOH, which is in a reference degradation state, based on estimation results in time series. The control unit 51 determines whether or not the acquired time variation in the difference between the current SOH of the second energy storage device and the reference degradation state, i.e., a time variation in a deviation of the degradation state of the second energy storage device from the reference degradation state, satisfies an allowable condition.

For example, when a temporal change in the difference indicates a decreasing or maintaining trend, or when a change amount of the difference over a predetermined period is less than an allowable threshold value set in advance, the control unit 51 determines not to output warning information. When the temporal change in the difference indicates an increasing trend, or when the change amount of the difference over a predetermined period is greater than or equal to an allowable threshold value set in advance, the control unit 51 determines to output warning information.

When it is determined that the warning information is not to be output (Step S41: NO), the control unit 51 ends the process. When it is determined that the warning information is to be outputted (Step S41: YES), the control unit 51 advances the process to Step S36 of the flowchart illustrated in FIG. 7, and generates and outputs the warning information.

In the above description, whether or not it is necessary to output warning information is determined based on a time variation in abnormality of a degradation state of the second energy storage device. Alternatively, the information processing apparatus 50 may determine whether or not it is necessary to output warning information, based on a time variation in abnormality of a degradation state of a first energy storage device.

According to the present embodiment, since it is possible to set whether or not it is necessary to output warning information in accordance with a time variation in a divergence of the degradation state of the energy storage device from the reference degradation state, it is possible to effectively notify only information with a high priority.

### (Fourth Embodiment)

In a fourth embodiment, a configuration in which, in addition to a future degradation state, a time at which the future degradation state deviates from a predetermined reference is presented will be explained. Hereinafter, differences from the first embodiment will be mainly explained, and configurations common to those of the first embodiment will be denoted by the same reference numerals, and detailed explanations thereof will be omitted.

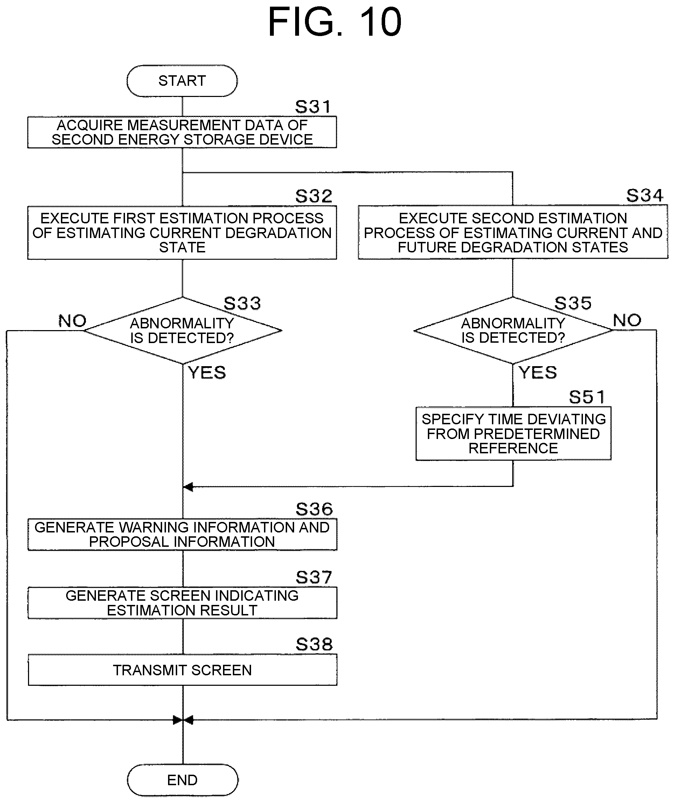

FIG. 10 is a flowchart illustrating an example of a processing procedure to be executed by an information processing apparatus 50 according to the fourth embodiment.

A control unit 51 of the information processing apparatus 50 executes a process in the same procedure as Steps S31 to S35 of the flowchart illustrated in FIG. 7, and performs abnormality detection of a second energy storage device. When it is determined that the future degradation state obtained by the first estimation process is abnormal (Step S35: YES), the control unit 51 specifies a time at which the future degradation state of the second energy storage device deviates from a predetermined reference (Step S51). The control unit 51 specifies the time at which the future degradation state deviates from a predetermined reference set in advance, based on an estimation result of the future degradation state obtained by a second estimation process. For example, the control unit 51 calculates, based on the life prediction graph indicating the degradation state illustrated in FIG. 8, a time at which an SOH value in the life prediction graph becomes equal to an SOH lower limit value set in advance.

Thereafter, the control unit 51 executes the same process as that in the flowchart illustrated in FIG. 7. In Step S37, the control unit 51 generates a screen indicating an estimation result including the specified time (life prediction result) at which a deviation from the predetermined reference occurs. The control unit 51 may display the specified life prediction result, for example, in the vicinity of the life prediction graph indicating the degradation state illustrated in FIG. 8.

In the above description, the time at which the future degradation state of the second energy storage device deviates from the predetermined reference is specified. Alternatively, the information processing apparatus 50 may specify a time at which a future degradation state of a first energy storage device deviates from a predetermined reference.

According to the present embodiment, since it is possible to easily grasp a life of the energy storage device when the current load and temperature are continued, it is possible to take a countermeasure corresponding to the life prediction result.

In the above-described embodiment, an example in which the information processing apparatus 50 executes each process in the above-described flowchart has been explained. Alternatively, a part or all of the above-described processes may be executed by other processing entities, such as a terminal apparatus 60, a domain management apparatus 30, or server equipment 20.

It should be understood that the embodiments disclosed herein are illustrative in all respects and are not restrictive. The technical features described in the embodiments can be combined with each other, and the scope of the present invention is intended to include all modifications within the scope of the claims and a scope equivalent to the scope of the claims.

The sequence illustrated in each embodiment is not limited, and each processing procedure may be executed by changing the order thereof, or a plurality of processes may be executed in parallel, to the extent that there is no internal contradiction. The processing entity of each process is not limited, and the processing of each apparatus may be executed by an other apparatus as long as there is no internal contradiction.

The matters described in the embodiments can be combined with each other. Further, the independent claims and dependent claims described in the scope of claims can be combined with each other, regardless of the citation form. Furthermore, a format (multi-claim format) in which a claim citing two or more other claims is described is used in the scope of the claims, but the present invention is not limited thereto. The present invention may be described by using a format of describing a multi-claim (multi-multi-claim) in which at least one multi-claim is cited.

### DESCRIPTION OF REFERENCE NUMERALS

100 Remote monitoring system (information processing system)
200 Power generation system
10 Communication device
11 Control unit
12 Storage unit
13 First communication unit
14 Second communication unit
20 Server equipment
30 Domain management apparatus
40 Energy storage unit
41 Bank
42 Energy storage module
43 Measurement substrate
44 Battery management unit
50 Information processing apparatus
51 Control unit
52 Storage unit
53 Communication unit
521 Program
522 Measurement DB
5A Recording medium
60 Terminal apparatus
61 Control unit
62 Storage unit
63 Communication unit
64 Display unit
65 Operation unit

## Claims

1. An information processing method comprising:
acquiring measurement data of a plurality of energy storage devices;
executing, based on measurement data of a first energy storage device group selected from the plurality of energy storage devices, a first process for estimating a degradation state of the first energy storage device group;
extracting, from among the plurality of energy storage devices, a second energy storage device to be subjected to a second process; and
executing, based on measurement data of the extracted second energy storage device, a second process for estimating a degradation state of the second energy storage device.

2. The information processing method according to claim 1, comprising
outputting warning information when an abnormality of the first energy storage device group or the second energy storage device is detected based on an estimation result from the first process or the second process.

3. The information processing method according to claim 1 or 2, comprising
generating proposal information regarding an operation of the plurality of energy storage devices, based on an estimation result from the first process or the second process.

4. The information processing method according to claim 1 or 2, wherein
the first process or the second process includes: a process for estimating a current degradation state; and a process for estimating a future degradation state.

5. The information processing method according to claim 1 or 2, comprising:
acquiring a distribution of the measurement data in the plurality of energy storage devices; and
extracting the second energy storage device, based on the acquired distribution of the measurement data.

6. The information processing method according to claim 1 or 2, comprising:
acquiring a voltage distribution in the plurality of energy storage devices, based on the measurement data of the plurality of energy storage devices; and
extracting, as the second energy storage device, an energy storage device whose difference from an average value or a median value of voltages calculated based on the acquired voltage distribution is greater than or equal to a predetermined value.

7. The information processing method according to claim 1 or 2, comprising
extracting any energy storage device in the first energy storage device group as the second energy storage device, based on an estimation result from the first process.

8. The information processing method according to claim 1 or 2, comprising
selecting the first energy storage device group, based on a distribution of loads or temperatures of the plurality of energy storage devices.

9. The information processing method according to claim 1 or 2, comprising:
executing the first process, based on the measurement data in a first period; and
executing the second process, based on the measurement data in a second period excluding a specific period from the first period.

10. The information processing method according to claim 1 or 2, wherein
the number of the plurality of energy storage devices is one million or more.

11. An information processing system comprising:
an acquisition unit that acquires measurement data of a plurality of energy storage devices;
a first processing unit that executes, based on measurement data of a first energy storage device group selected from the plurality of energy storage devices, a first process for estimating a degradation state of the first energy storage device group;
an extraction unit that extracts, from among the plurality of energy storage devices, a second energy storage device to be subjected to a second process; and
a second processing unit that executes, based on measurement data of the extracted second energy storage device, a second process for estimating a degradation state of the second energy storage device.

12. A program causing a computer to execute:
acquiring measurement data of a plurality of energy storage devices;
executing, based on measurement data of a first energy storage device group selected from the plurality of energy storage devices, a first process for estimating a degradation state of the first energy storage device group;
extracting, from among the plurality of energy storage devices, a second energy storage device to be subjected to a second process; and
executing, based on measurement data of the extracted second energy storage device, a second process for estimating a degradation state of the second energy storage device.
